# EUROPÄISCHE PATENTSCHRIFT

(11) **EP 1 532 690 B1**
(45) Veröffentlichungstag und Bekanntmachung des Hinweises auf die Patenterteilung: **10.05.2017**
(21) Anmeldenummer: 03790861.3
(22) Anmeldetag: 05.08.2003
(51) Int. Cl.: G01J 1/08, H01L 31/18, H01L 27/144

(54) **VERFAHREN ZUR KALIBRIERUNG EINES LICHTEMPFINDLICHEN INTEGRIERTEN SCHALTKREISES**
METHOD FOR CALIBRATION OF A LIGHT-SENSITIVE INTEGRATED CIRCUIT
PROCÉDÉ POUR ÉTALONNER UN CIRCUIT INTÉGRÉ SENSIBLE À LA LUMIÈRE

(30) Priorität: 30.08.2002 DE 10240083
(43) Veröffentlichungstag der Anmeldung: 25.05.2005
(73) Patentinhaber: ams AG, 8141 Premstätten (AT)
(72) Erfinder: MUELLER, Thomas, 8010 Graz (AT)
(74) Vertreter: Epping - Hermann - Fischer
(86) Internationale Anmeldenummer: PCT/EP2003/008665
(87) Internationale Veröffentlichungsnummer: WO 2004/021454

(56) Entgegenhaltungen:
- WO-A-01/86723
- WO-A-97/24728

## Beschreibung

Die Erfindung betrifft ein Verfahren zur Kalibrierung einer Fotodiode, wobei die Ausgangssignale der Fotodiode bei verschiedenen Meß-Wellenlängen gemessen werden.

Es sind lichtempfindliche integrierte Schaltkreise bekannt, die bei Bestrahlung mit Licht einer bestimmten Wellenlänge ein elektrisches Ausgangssignal, beispielsweise einen elektrischen Strom liefern. Interferenzen an den der Lichtquelle zugewandten Oberflächen des lichtempfindlichen integrierten Schaltkreises sowie weitere Effekte bewirken, daß das von dem integrierten Schaltkreis erzeugte elektrische Signal stark von der eingestrahlten Lichtwellenlänge abhängt. Dieser Effekt ist bei der genauen Messung von Licht mittels integrierter Schaltkreise unerwünscht.

Um die Wellenlängenabhängigkeit des ausgegebenen Signals zu vermindern, ist es aus der Druckschrift US 4,131,488 bekannt, auf der der Lichtquelle zugewandten Oberfläche des lichtempfindlichen integrierten Schaltkreises eine Antireflex-Beschichtung aufzubringen. Eine solche Beschichtung hat den Nachteil, daß sie einen zusätzlichen Prozeßschritt bei der Herstellung des Lichtsensors erfordert.

Dokument WO 01/86723 A1 beschreibt einen optischen Mikrosensor für mehrere Wellenlängen, ein Spektrophotometer und einen Polychromator. Der Mikrosensor umfasst einen Speicher, der es ermöglicht, ein Programm zur Signalverarbeitung zu speichern. Der Sensor kann die spektrale Antwort linearisieren.

Dokument WO 97/24728 A1 befasst sich mit einem CMOS-Bauelement zur Bildaufnahme, welches einen integrierten Flash-Speicher zur Bildkorrektur aufweist. Ein Sensorarray wird von einer Lichtquelle beleuchtet und Unterschiede in der Größe der Ausgangssignale der einzelnen Elemente des Sensorarrays werden ermittelt und daraus Kompensationswerte berechnet.

Es ist daher Aufgabe der vorliegenden Erfindung, ein Verfahren zur Einstellung des wellenlängenabhängigen Ausgangssignals eines lichtempfindlichen integrierten Schaltkreises anzugeben, was die Notwendigkeit von Antireflexschichten vermeidet und was eine hohe Flexibilität hinsichtlich der einzustellenden Wellenlängenabhängigkeit des Ausgangssignals aufweist.

Die Aufgabe wird gelöst durch ein Verfahren gemäß Patentanspruch 1. Vorteilhafte Ausgestaltungen des Verfahrens sind den weiteren Patentansprüchen zu entnehmen.

Es wird ein Verfahren zur Einstellung des wellenlängenabhängigen Ausgangssignals eines lichtempfindlichen integrierten Schaltkreises angegeben, wobei die Ausgangssignale des integrierten Schaltkreises bei verschiedenen Wellenlängen gemessen werden. Die bei jeder Wellenlänge gemessenen Meßwerte werden mit vorgegebenen Sollwerten verglichen. Dabei gibt es für jede gemessene Wellenlänge einen Sollwert. Durch Vergleich zwischen den Meßwerten und den Sollwerten werden Korrekturwerte berechnet. Informationen über diese Korrekturwerte werden dauerhaft in dem integrierten Schaltkreis gespeichert.

Indem gemäß dem Verfahren Korrekturwerte beziehungsweise Informationen über Korrekturwerte direkt auf dem integrierten Schaltkreis gespeichert werden und nachfolgend zur Anpassung der Ausgangssignale dienen können, kann auf technologische Maßnahmen auf der Oberfläche des integrierten Schaltkreises zur Eliminierung unerwünschter Wellenlängenabhängigkeiten des Ausgangssignals verzichtet werden.

Das Verfahren zur Einstellung des wellenlängenabhängigen Ausgangssignals hat den Vorteil, daß es nicht auf die Eliminierung unerwünschter Signalschwankungen bei unterschiedlicher Wellenlänge beschränkt ist. Vielmehr kann jede beliebige Wellenlängencharakteristik für den lichtempfindlichen integrierten Schaltkreis eingestellt werden.

In einer Ausführungsform des Verfahrens wird ein integrierter Schaltkreis verwendet, der Bestandteil eines Halbleitersubstrats ist. Die Einstellung erfolgt mittels einer Prüfkarte für integrierte Schaltkreise.

Im Verfahren werden als Lichtquellen zur Messung der Ausgangssignale mehrere lichtemittierende Dioden verwendet. Solche LED haben den Vorteil, daß sie bei einer festen Frequenz Licht emittieren und ferner, daß sie ein sehr genau bekanntes Verhalten ihrer optischen Leistungsdichte in Abhängigkeit des an die LED angelegten Stromes aufweisen. LED haben ferner den Vorteil, daß sie leicht und billig herstellbar und somit für das hier angegebene Verfahren vorteilhaft einsetzbar sind.

Ferner haben LED den Vorteil, daß sie bei sehr vielen verschiedenen Wellenlängen verfügbar sind.

In einer Ausführungsform des Verfahrens wird ein integrierter Schaltkreis verwendet, dessen wellenlängenabhängige Empfindlichkeit wellenförmig verläuft. Der kleinste Abstand zwischen zwei gemessenen Wellenlängen wird so gewählt, daß er kleiner ist als jeder Abstand zwischen einem relativen Empfindlichkeitsmaximum und einem relativen Empfindlichkeitsminimum. Somit ist gewährleistet, daß die Bestimmung der Ist-Charakteristik des fotoempfindlichen Bauelements hinreichend genau erfolgt, und daß nicht etwa durch Vorhandensein von relativen Maxima oder Minima zwischen zwei Meßpunkten die lineare Interpolation zwischen den Meßpunkten zu erheblichen Meßfehlern führt.

In einer anderen Ausführungsform des Verfahrens wird für die gemessenen Werte mittels Interpolation eine Empfindlichkeitskurve ermittelt, die mit einer Sollkurve verglichen wird. Aus diesem Vergleich wird eine Korrekturkurve berechnet, wobei Informationen über diese Korrekturkurve dauerhaft in dem integrierten Schaltkreis gespeichert werden.

In einer Ausführungsform des Verfahrens wird ein integrierter Schaltkreis verwendet, der eine oder mehrere Fotodioden umfaßt. Fotodioden können aufgrund ihrer gut bekannten Eigenschaften, insbesondere auch der gut bekannten Abhängigkeit des Ausgangssignals von der optischen Leistungsdichte, die auf das Bauelement eingestrahlt wird, gut für den hier verfolgten Zweck angewendet werden.

Solche Fotodioden erlaubt es nämlich, die Kalibration, also die Einstellung der wellenlängenabhängigen Ausgangssignale mit Leuchtdioden durchzuführen, die nicht alle die gleiche optische Leistungsdichte auf dem lichtempfindlichen integrierten Schaltkreis liefern. Es genügt vielmehr, wenn für jede Meßfrequenz, also für jede Leuchtdiode die optische Leistungsdichte auf der Oberfläche des lichtempfindlichen integrierten Schaltkreises bekannt ist. Eine Normierung der gemessenen Signale auf eine einheitliche optische Leistungsdichte kann ohne weiteres mit einfachen Mitteln erfolgen.

In einer Ausführungsform des Verfahrens werden zur Speicherung der Informationen auf dem integrierten Schaltkreis Zener-Dioden verwendet. Es können jedoch auch andere Speichermedien, die eine dauerhafte Speicherung von Informationen erlauben, verwendet werden. Beispielsweise kommen in Frage Sicherungen enthaltend polykristallines Silizium, oder auch sogenanntes "Lasertrimming", wo mittels eines Lasers durch Wegschmelzen von Widerstandsmaterial Widerstandswerte dauerhaft geändert werden. Eine andere Möglichkeit, Informationen auf dem integrierten Schaltkreis zu speichern, besteht in der Verwendung von EEPROM = "Electrically Erasable Programmable Read Only Memory".

Es wird ferner ein Halbleiterchip angegeben, der einen lichtempfindlichen integrierten Schaltkreis enthält. Auf dem lichtempfindlichen integrierten Schaltkreis ist Information gespeichert zur Korrektur des wellenlängenabhängigen Ausgangssignals des integrierten Schaltkreises. Ein solcher Halbleiterchip hat den Vorteil, daß wellenlängenabhängige optische Messungen durchgeführt werden können, wobei die auf den Chip gespeicherten Daten es erlauben, die Wellenlängenabhängigkeit zu eliminieren oder auch in eine vorgegebene Wellenlängenabhängigkeit abzuändern.

In einer Ausführungsform des Halbleiterchips ist zusätzlich ein Temperatursensor zur Messung der Temperatur einer externen Lichtquelle vorgesehen, und es sind ferner Korrekturdaten auf dem Chip gespeichert, die zur Korrektur der temperaturabhängigen Wellenlänge der externen Lichtquelle dienen.

Ein solcher Halbleiterchip hat den Vorteil, daß die Messung von Lichtquellen, deren optische Leistungsdichte von der Temperatur abhängig ist, in sehr genauer Art und Weise ermöglicht wird.

Es wird ferner ein Verfahren zum Betrieb eines Halbleiterchips angegeben, wobei eine externe Lichtquelle den integrierten Schaltkreis beleuchtet und somit ein Ausgangssignal erzeugt wird. Es wird während der Messung die Information über die Wellenlänge der Lichtquelle auf den integrierten Schaltkreis übertragen. Anhand der übertragenen Wellenlänge und mit Hilfe der auf dem integrierten Schaltkreis gespeicherten Information zur Korrektur des wellenlängenabhängigen Ausgangssignals des integrierten Schaltkreises kann das wellenlängenabhängige Ausgangssignal des integrierten Schaltkreises korrigiert beziehungsweise verändert werden.

In einer Ausführungsform des Verfahrens wird durch Verwendung eines geeigneten Halbleiterchips die Temperatur der externen Lichtquelle gemessen. Die auf den Chip übertragene Information über die Wellenlänge der externen Lichtquelle wird mittels der gemessenen Temperatur und den entsprechenden Korrekturdaten, welche ebenfalls auf dem Chip gespeichert sind, korrigiert und sodann für die Korrektur der Wellenlängenabhängigkeit des Ausgangssignals verwendet.

Im folgenden wird die Erfindung anhand von Ausführungsbeispielen und den dazugehörigen Figuren näher erläutert.
- Figur 1: zeigt eine Meßanordnung zur Durchführung des angegebenen Verfahrens.
- Figur 2: zeigt die wellenlängenabhängige Empfindlichkeit eines lichtempfindlichen integrierten Schaltkreises beispielhaft in einer schematischen Darstellung.
- Figur 3: zeigt beispielhaft einen angegebenen Halbleiterchip in einer Draufsicht.

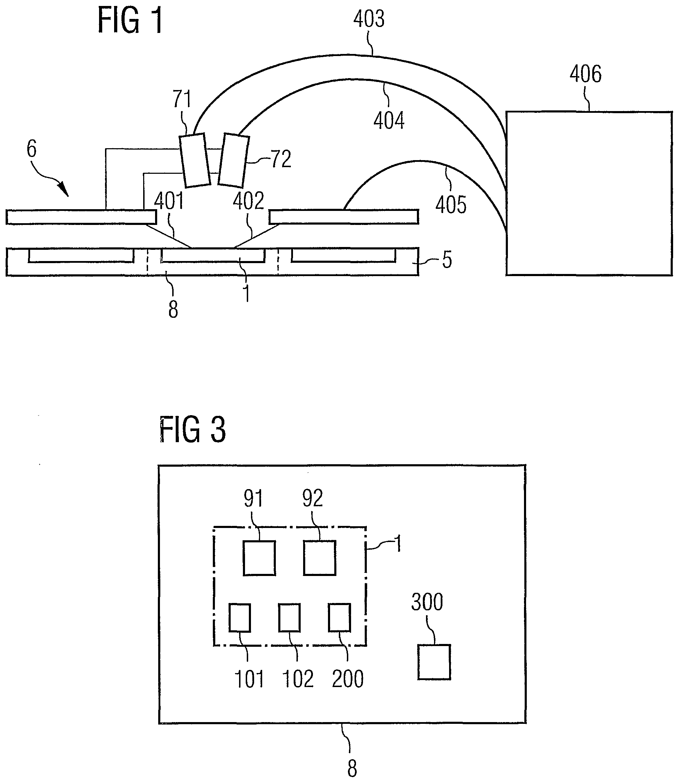

Figur 1 zeigt eine Anordnung zur Durchführung des Verfahrens. Es ist ein Halbleitersubstrat 5 vorgesehen, welches einen lichtempfindlichen integrierten Schaltkreis 1 beinhaltet. Das Halbleitersubstrat 5 kann beispielsweise ein Siliziumwafer sein. Der lichtempfindliche integrierte Schaltkreis 1 kann in einem späteren Herstellungsschritt zu einem Halbleiterchip 8 vereinzelt werden. Über dem Halbleitersubstrat 5 ist eine Prüfkarte 6 für integrierte Schaltkreise angeordnet. Auf der Oberseite der Prüfkarte 6 sind Leuchtdioden 71, 72 montiert. Diese Leuchtdioden 71, 72 bestrahlen den lichtempfindlichen integrierten Schaltkreis 1 mit Licht unterschiedlicher Wellenlänge. Dabei unterscheidet sich die Wellenlänge des Lichts, mit dem die Leuchtdiode 71 den lichtempfindlichen integrierten Schaltkreis 1 beleuchtet von der Wellenlänge des Lichts, mit dem die Leuchtdiode 72 den lichtempfindlichen integrierten Schaltkreis 1 beleuchtet. Die Leuchtdioden 71, 72 sind mittels Verbindungsleitungen 403, 404 mit einem Testsystem 406 verbunden, welches die Leuchtdioden 71, 72 mit Strom versorgt. Die Prüfkarte 6 ist ihrerseits nochmals selbständig mittels einer oder mehrerer Verbindungsleitungen 405 mit dem Testsystem 406 verbunden. Zur Kontaktierung der Prüfkarte 6 mit dem Halbleitersubstrat 5 sind Prüfnadeln 401, 402 vorgesehen. Diese Prüfnadeln 401, 402 dienen dazu, auf vorgesehenen Kontaktflächen des empfindlichen integrierten Schaltkreises 1 aufzusetzen und entweder den im lichtempfindlichen integrierten Schaltkreis 1 erzeugten Strom aufzunehmen oder um Daten auf dem lichtempfindlichen integrierten Schaltkreis 1 zu speichern.

Es ist noch darauf hinzuweisen, daß die Prüfkarte 6 derart ausgestaltet ist, daß die auf der Oberseite der Prüfkarte 6 angeordneten Leuchtdioden 71, 72 den unter der Prüfkarte 6 angeordneten lichtempfindlichen integrierten Schaltkreis 1 beleuchten können. Eine solche geeignete Gestaltung der Prüfkarte 6 kann beispielsweise darin bestehen, daß die Prüfkarte 6 an der Beleuchtungsstelle des lichtempfindlichen integrierten Schaltkreises 1 einen Durchbruch aufweist.

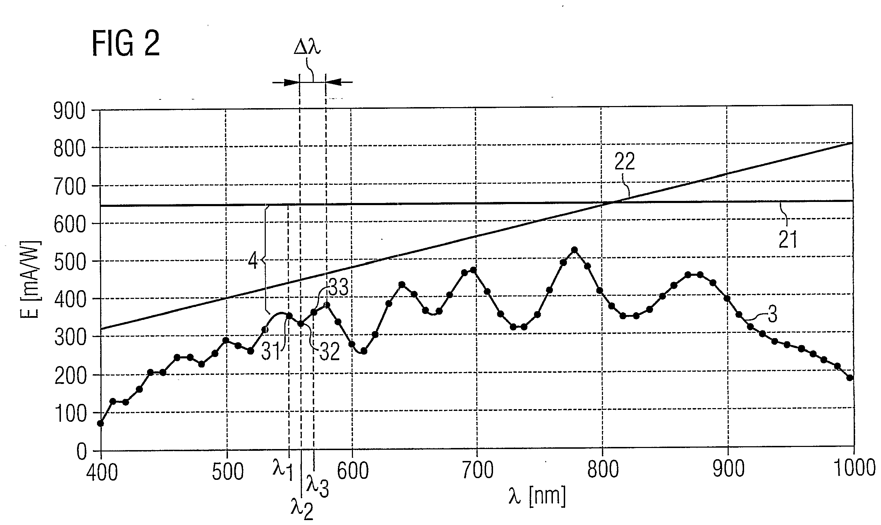

Figur 2 zeigt die mittels der Anordnung aus Figur 1 gemessenen Ausgangssignale einer auf dem lichtempfindlichen integrierten Schaltkreis befindlichen Fotodiode. Es ist dabei die Empfindlichkeit E der Fotodiode, gemessen in mA pro Watt eingestrahlte optische Leistung aufgetragen über die eingestrahlte Wellenlänge λ, aufgetragen in der Einheit nm. Figur 2 zeigt eine Empfindlichkeitskurve 3, die durch Interpolation aus den mittels der Anordnung von Figur 1 gemessenen wellenlängenabhängigen Empfindlichkeiten der Fotodiode ermittelt werden kann. Es ist darauf hinzuweisen, daß die Kurve 3 für jeden Chip eine etwas andere Form haben kann, abhängig von den Fertigungstoleranzen, die das Interferenzmuster um bis zu 20 µm verschieben können.

Die Abstände der Meß-Wellenlängen λ1, λ2, λ3 sind dabei so gewählt, daß die Abstände, repräsentiert durch Differenzen zwischen zwei Wellenlängen, z. B. λ2 - λ1, kleiner sind als die Abstände Δλ zwischen einem relativen Minimum und einem relativen Maximum der Empfindlichkeitskurve 3.

Es kann aber auch mit Meß-Wellenlängen inter- bzw. extrapoliert werden, deren Abstände größer als Δλ sind, falls noch zusätzliche Informationen über die Eigenschaften der Empfindlichkeitskurve auf dem Chip speichert und lediglich kleine Änderungen korrigiert.

Die somit gemessenen Empfindlichkeiten der Fotodiode können dazu verwendet werden, um in dem Testsystem 406 mit einer gewünschten Soll-Empfindlichkeit verglichen zu werden. In Figur 2 sind verschiedene Sollkurven 21, 22 beispielhaft angegeben. Beispielsweise könnte die Sollkurve 21 verwendet werden, falls es lediglich gewünscht ist, die Oszillationen der Empfindlichkeitskurve 3 zu eliminieren und ein wellenlängenunabhängiges Ausgangssignal der Fotodiode zu erzeugen. In diesem Fall würde für jeden zu einer Meßwellenlänge λ1, λ2, λ3 gehörigen Meßwert 31, 32, 33 ein Korrekturwert 4 berechnet, der zum Beispiel den Unterschied zwischen dem bei der Wellenlänge λ1 gemessenen Meßwert 31 und dem bei der Wellenlänge λ1 angegebenen Wert der Sollkurve 21 repräsentiert. Es ist in diesem Zusammenhang darauf hinzuweisen, daß der Korrekturwert 4 nicht zwingend die einfache Differenz des Wertes der Sollkurve 21 bei der Wellenlänge λ1 und dem Meßwert 31 bei der Wellenlänge λ1 darstellt. Der Korrekturwert 4 kann auch einen Korrekturfaktor oder eine kompliziertere Korrekturfunktion repräsentieren.

Als weiteres Beispiel ist in Figur 2 die Sollkurve 22 gezeigt, die verwendet wird, wenn die Lichtempfindlichkeit der Fotodiode mit der Lichtwellenlänge linear anwachsen soll. Die Korrektur kann dabei analog zu der zur Sollkurve 21 beschriebenen Art und Weise erfolgen.

Die Korrekturwerte 4 werden nach Durchführung der Messung und nach Durchführung des Vergleichs, beispielsweise im Testsystem 406, auf dem lichtempfindlichen integrierten Schaltkreis gespeichert. Es können aber auch nur Informationen über die Korrekturwerte 4, zum Beispiel in Form einer interpolierten Kurve, gespeichert werden.

Figur 3 zeigt beispielhaft einen Halbleiterchip 8, der für das Verfahren gemäß Figur 1 und Figur 2 verwendet werden kann beziehungsweise der ein Endprodukt des Verfahrens darstellt. Der Halbleiterchip 8 umfaßt einen lichtempfindlichen integrierten Schaltkreis 1, welcher seinerseits Fotodioden 91, 92 sowie Zener-Dioden 101, 102 und weitere Schaltkreise 200 umfaßt. Nach Abschließen der Messung, wie in Figur 2 beschrieben, werden Korrekturwerte 4 oder eine ganze Korrekturkurve auf dem Halbleiterchip 8 gespeichert. Das Speichern erfolgt mit Hilfe beispielsweise der Zener-Dioden 101, 102, die durch einmaliges Anlegen eines Stromes in ihren elektrischen Eigenschaften dauerhaft verändert werden können.

Es kann ferner auf dem Halbleiterchip 8 ein Temperatursensor 300 vorgesehen sein, der beispielsweise ein On-Chip-Temperatursensor sein kann, welcher polykristallines Silizium enthält.

Für den Fall, daß Information über eine ganze Korrekturkurve, also für alle Wellenlängen in einem bestimmten Wellenlängenbereich, auf dem integrierten Schaltkreis gespeichert ist, kann bei jeder beliebigen Wellenlänge in dem Wellenlängenbereich eine Korrektur sowohl hinsichtlich der Empfindlichkeit der Fotodiode auf dem Chip als auch hinsichtlich der Temperaturabhängigkeit der Strahlungsquelle, jedoch nur bei bekannten Temperaturverhalten der Strahlungsquelle, durchgeführt werden.

## Patentansprüche

1. Verfahren zur Einstellung eines wellenlängenabhängigen Ausgangssignals eines lichtempfindlichen integrierten Schaltkreises (1),
- wobei die Ausgangssignale des integrierten Schaltkreises (1) bei verschiedenen Meß-Wellenlängen (λ1, λ2, λ3) gemessen werden,
- wobei die Meßwerte (31, 32, 33) mit für jede Meß-Wellenlänge (λ1, λ2, λ3) vorgegebenen Sollwerten (21, 22) verglichen und aus dem Vergleich Korrekturwerte (4) berechnet werden,
- wobei Informationen über die Korrekturwerte (4) dauerhaft in dem integrierten Schaltkreis (1) gespeichert werden,
- wobei ein integrierter Schaltkreis (1) verwendet wird, der Bestandteil eines Halbleitersubstrats (5) ist,
**dadurch gekennzeichnet, dass**
- die Einstellung mittels einer Prüfkarte (6) für integrierte Schaltkreise erfolgt und die Prüfkarte (6) über dem Halbleitersubstrat (5) angeordnet ist,
- wobei auf der Oberseite der Prüfkarte (6) lichtemittierende Dioden (71, 72) montiert sind, die den lichtempfindlichen integrierten Schaltkreis (1) mit Licht unterschiedlicher Wellenlänge bestrahlen, und
- wobei als Lichtquelle für jede Meß-Wellenlänge (λ1, λ2, λ3) eine lichtemittierende Diode (71, 72) verwendet wird.

2. Verfahren nach Anspruch 1,
- wobei ein integrierter Schaltkreis (1) verwendet wird, dessen wellenlängenabhängige Empfindlichkeit wellenförmig verläuft,
- und wobei der kleinste Abstand zwischen zwei Meß-Wellenlängen (λ1, λ2, λ3) so gewählt wird, daß er kleiner ist als jeder Abstand (Δλ) zwischen einem relativen Empfindlichkeitsmaximum und einem relativen Empfindlichkeitsminimum der wellenlängenabhängigen Empfindlichkeit.

3. Verfahren nach Anspruch 2,
- wobei für die Meßwerte (31, 32, 33) mittels Interpolation eine Empfindlichkeitskurve (3) ermittelt wird, die mit einer Sollkurve (21, 22) verglichen wird, woraus eine Korrekturkurve berechnet wird,
- und wobei Informationen über die Korrekturkurve dauerhaft in dem integrierten Schaltkreis (1) gespeichert werden.

4. Verfahren nach einem der Ansprüche 1 bis 3,
wobei der integrierte Schaltkreis (1) eine oder mehrere Fotodioden (91, 92) enthält.

5. Verfahren nach einem der Ansprüche 1 bis 4,
wobei zur Speicherung von Informationen auf dem integrierten Schaltkreis (1) Zener-Dioden (101, 102) verwendet werden.

6. Verfahren nach einem der Ansprüche 1 bis 5,
wobei zur Kontaktierung der Prüfkarte (6) mit dem Halbleitersubstrat (5) Prüfnadeln (401, 402) vorgesehen sind.

7. Verfahren nach Anspruch 6,
wobei die Prüfnadeln (401, 402) dazu dienen, auf vorgesehenen Kontaktflächen des empfindlichen integrierten Schaltkreises (1) aufzusetzen und entweder den im lichtempfindlichen integrierten Schaltkreis (1) erzeugten Strom aufzunehmen oder um Daten auf dem lichtempfindlichen integrierten Schaltkreis (1) zu speichern.

8. Verfahren nach einem der Ansprüche 1 bis 7,
wobei die Prüfkarte (6) derart ausgestaltet ist, daß die auf der Oberseite der Prüfkarte (6) angeordneten lichtemittierende Dioden (71, 72) den unter der Prüfkarte (6) angeordneten lichtempfindlichen integrierten Schaltkreis (1) beleuchten können, dadurch dass die Prüfkarte (6) an der Beleuchtungsstelle des lichtempfindlichen integrierten Schaltkreises (1) einen Durchbruch aufweist.

## Claims

1. A method for adjusting a wavelength-dependent output signal of a light-sensitive integrated circuit (1),
- wherein the output signals of the integrated circuit (1) are measured at various measuring wavelengths (λ1, λ2, λ3),
- wherein the measured values (31, 32, 33) are compared to set point values (21, 22) defined for each measuring wavelength (λ1, λ2, λ3), and correction values (4) are calculated from the comparison,
- wherein information on the correction values (4) is permanently stored in the integrated circuit (1),
- wherein an integrated circuit (1) is used which is part of a semiconductor substrate (5),
**characterized in that**
- the adjusting is performed by means of a test card (6) for integrated circuits, and the test card (6) is arranged above the semiconductor substrate (5),
- wherein light-emitting diodes (71, 72) are mounted on the upper side of the test card (6) which irradiate the light-sensitive integrated circuit (1) with light of different wavelength, and
- wherein a light-emitting diode (71, 72) is used as a light source for each measuring wavelength (λ1, λ2, λ3).

2. The method according to claim 1,
- wherein an integrated circuit (1) is used whose wavelength-dependent sensitivity proceeds in a wave shape,
- and wherein the smallest distance between two measuring wavelengths (λ1, λ2, λ3) is selected so as to be smaller than any distance (Δλ) between a relative sensitivity maximum and a relative sensitivity minimum of the wavelength-dependent sensitivity.

3. The method according to claim 2,
- wherein for the measured values (31, 32, 33) a sensitivity curve (3) is determined by means of interpolation which is compared to a set point curve (21, 22), a correction curve being calculated from said comparison,
- and wherein information on the correction curve is permanently stored in the integrated circuit (1).

4. The method according to any one of claims 1 to 3, wherein the integrated circuit (1) includes one or more photodiodes (91, 92).

5. The method according to any one of claims 1 to 4, wherein Zener diodes (101, 102) are used for storing information in the integrated circuit (1).

6. The method according to any one of claims 1 to 5, wherein testing needles (401, 402) are provided for contacting the test card (6) to the semiconductor substrate (5).

7. The method according to claim 6,
wherein the testing needles (401, 402) serve to touch down on intended contact surfaces of the sensitive integrated circuit (1) and either to pick up the current generated in the light-sensitive integrated circuit (1) or to store data onto the light-sensitive integrated circuit (1).

8. The method according to any one of claims 1 to 7, wherein the test card (6) is configured such that the light-emitting diodes (71, 72) arranged on the test card's (6) upper side are able to illuminate the light-sensitive integrated circuit (1) arranged below the test card (6) due to the fact that the test card (6) exhibits an opening at the illuminating location of the light-sensitive integrated circuit (1).

## Revendications

1. Procédé pour le réglage d'un signal de sortie à dépendance de longueur d'onde d'un circuit intégré sensible à la lumière (1),
- sachant que les signaux de sortie du circuit intégré (1) sont mesurés pour diverses longueurs d'onde de mesure (λ1, λ2, λ3),
- sachant que les valeurs de mesure (31, 32, 33) sont comparées à des valeurs de consigne (21, 22) spécifiées pour chaque longueur d'onde de mesure (λ1, λ2, λ3) et des valeurs de correction (4) sont calculées à partir de la comparaison,
- sachant que des informations sur les valeurs de correction (4) sont durablement enregistrées dans le circuit intégré (1),
- sachant qu'un circuit intégré (1) qui fait partie intégrante d'un substrat semiconducteur (5) est employé,
**caractérisé en ce que**
- le réglage s'effectue au moyen d'une carte de contrôle (6) pour circuits intégrés et la carte de contrôle (6) est disposée au-dessus du substrat semiconducteur (5),
- sachant que sur la face supérieure de la carte de contrôle (6) sont montées des diodes luminescentes (71, 72) qui projettent de la lumière de différente longueur d'onde sur le circuit intégré (1) sensible à la lumière, et
- sachant qu'une diode luminescente (71, 72) est employée comme source de lumière pour chaque longueur d'onde de mesure (λ1, λ2, λ3).

2. Procédé selon la revendication 1,
- sachant qu'un circuit intégré (1) dont la sensibilité dépendant de la longueur d'onde présente une allure ondulée est employé,
- et sachant que le plus petit écart entre deux longueurs d'onde de mesure (λ1, λ2, λ3) est choisi de façon à être plus petit que tout écart (Δλ) entre un maximum de sensibilité relatif et un minimum de sensibilité relatif de la sensibilité dépendant de la longueur d'onde.

3. Procédé selon la revendication 2,
- sachant qu'une courbe de sensibilité (3) est déterminée par interpolation pour les valeurs de mesure (31, 32, 33), laquelle est comparée à une courbe de consigne (21, 22), une courbe de correction étant calculée à partir de cette comparaison,
- et sachant que des informations sur la courbe de correction sont durablement enregistrées dans le circuit intégré (1).

4. Procédé selon l'une des revendications 1 à 3,
sachant que le circuit intégré (1) contient une ou plusieurs photodiodes (91, 92).

5. Procédé selon l'une des revendications 1 à 4,
sachant que des diodes Zener (101, 102) sont employées pour l'enregistrement d'informations sur le circuit intégré (1).

6. Procédé selon l'une des revendications 1 à 5,
sachant que des aiguilles de contrôle (401, 402) sont prévues pour la mise en contact de la carte de contrôle (6) avec le substrat semiconducteur (5).

7. Procédé selon la revendication 6,
sachant que les aiguilles de contrôle (401, 402) servent à se poser sur des faces de contact prévues du circuit intégré (1) sensible et soit à absorber le courant généré dans le circuit intégré (1) sensible à la lumière, soit à enregistrer des données sur le circuit intégré (1) sensible à la lumière.

8. Procédé selon l'une des revendications 1 à 7,
sachant que la carte de contrôle (6) est configurée de telle sorte que les diodes luminescentes (71, 72) disposées sur la face supérieure de la carte de contrôle (6) peuvent éclairer le circuit intégré (1) sensible à la lumière disposé sous la carte de contrôle (6) du fait que la carte de contrôle (6) présente une ouverture à l'endroit d'éclairage du circuit intégré (1) sensible à la lumière.
